# EUROPEAN PATENT SPECIFICATION

(11) **EP 1 411 407 B1**
(45) Date of publication and mention of the grant of the patent: **08.08.2007**
(21) Application number: 03022468.7
(22) Date of filing: 08.10.2003
(51) Int. Cl.: G05F 3/20, G05F 1/46

(54) **Circuit and method for generating an internal operating voltage**
Schaltung und Verfahren zum Erzeugen einer internen Betriebsspannung
Circuit et méthode pour générer une tension d'opération interne

(30) Priority: 15.10.2002 US 272404
(43) Date of publication of application: 21.04.2004
(73) Proprietor: SAMSUNG ELECTRONICS CO., LTD., 442-370 Suwon-city, Kyunggi-do (KR)
(72) Inventor: Lee, June, Seoul (KR)
(74) Representative: Patentanwälte Ruff, Wilhelm, Beier, Dauster & Partner

(56) References cited:
- US-A- 5 504 452
- US-A- 5 936 388
- US-A- 6 087 813
- US-A1- 2002 089 370
- US-B1- 6 320 454

## Description

This invention relates to a circuit and a method for generating an internal operating voltage for use in a memory device, such as a semiconductor memory device having an internal supply voltage driver to provide internal supply voltage.

As the integration density of semiconductor memory devices increases and the high power up speed is required, the structure of internal supply voltage generating means of a memory cell array is very important especially in hand-held systems. Namely, when the internal supply voltage rises with the external supply voltage, the internal supply voltage reaches a level where the memory device can operate in a stabilized state after the external supply voltage reaches the appropriate level. This difference in rising time of the voltage level causes various problems.

For example, when a system accesses the semiconductor memory device, if the system accesses the memory device only according to the external supply voltage level, there is a possibility that the system uses the internal supply voltage that has not yet reached the minimum voltage level for operating the memory device. It means that the semiconductor memory device will incur errors.

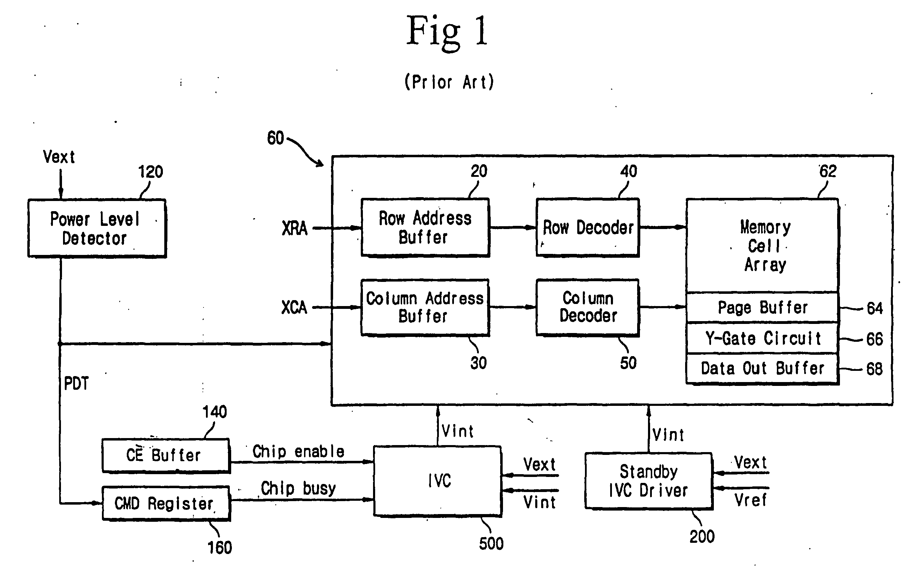

Fig. 1 is a block diagram of the conventional memory device. In this figure, the memory device will be considered as a flash memory device.

The memory device comprises an internal circuit 60, an Internal Voltage Converter (IVC) 500, a standby IVC driver 200, a power level detector 120, a CE buffer 140 and a CMD buffer 160. During the power-up period, the power level detector 120 generates a signal PDT with the external supply voltage. The signal PDT inputs to the internal circuits 60 and the CMD register 160 to reset the level in the memory device. The standby IVC driver 200 converts the external supply voltage to the internal supply voltage according to the level of reference voltage Vref. The standby IVC driver 200 always provides the internal voltage to the internal circuits after power up.

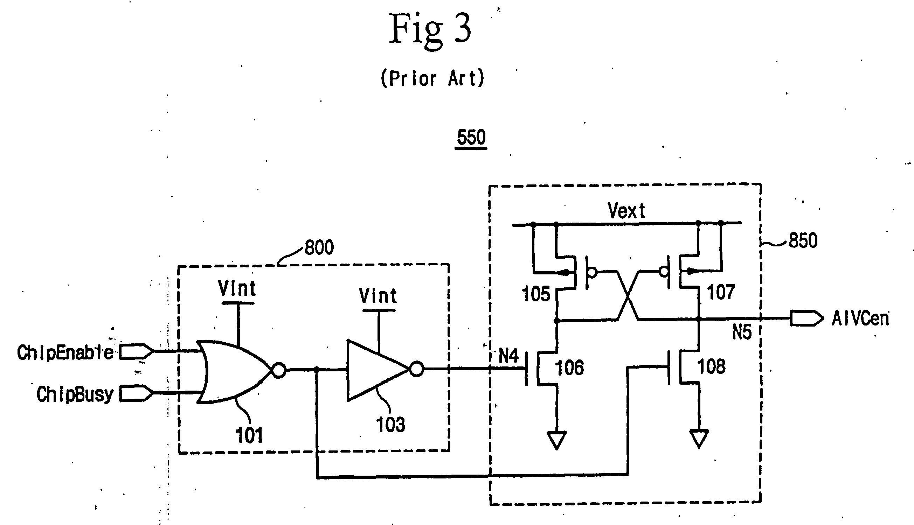

In Fig. 1, the IVC 500 comprises an active IVC controller and an active IVC driver. The active IVC controller (550 in Fig. 3) is activated only when CE buffer 140 and CMD register 160 generate an enable and busy signal, respectively. Those of skill in the art will appreciate that a standby IVC driver 200 is used in the standby mode for reducing the power consumption and the active IVC driver (550) is used during periods of active device operation to supply a sufficiently high voltage quickly to the memory device even when power consumption is high.

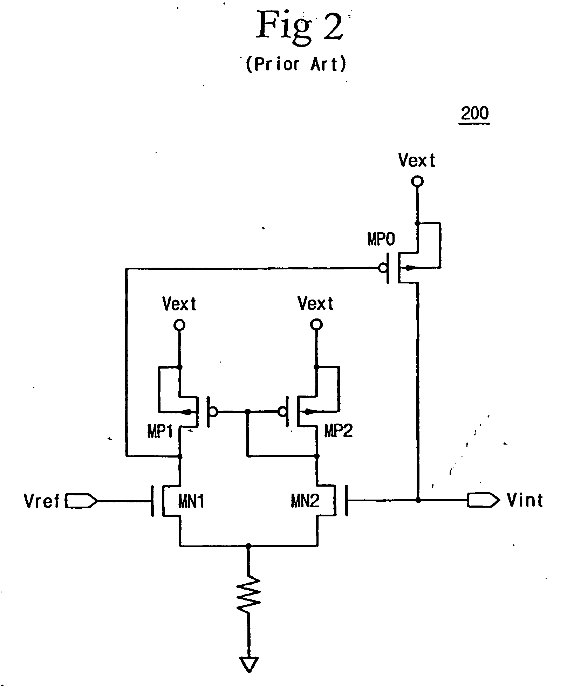

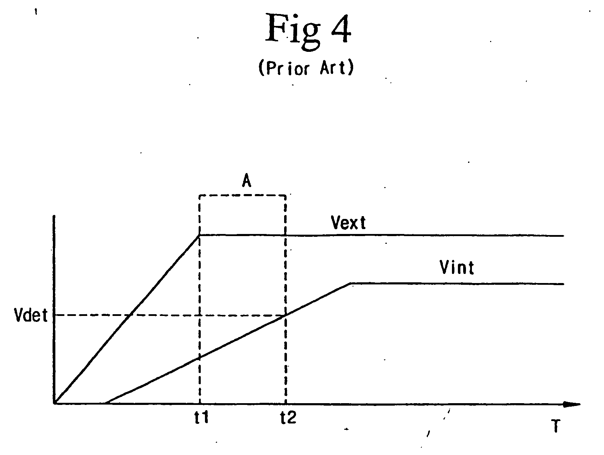

The circuit depicted in Fig. 2 is generally used in standby IVC driver 200. In Fig. 2, during power up, the standby IVC driver 200 receives a reference voltage Vref and an external supply voltage Vext to generate the internal voltage Vint. In the standby IVC driver, no signals are input to the driver 200 except the reference voltage Vref. Vref itself does not comprise other signals. Vref is controlled only by external voltage Vext. Because the standby IVC driver 200 always operates during the period of active device operation, driver 200 must generate an internal supply voltage Vint according to the level of reference voltage Vref. During that time, the power-up slopes of Vext and Vint are different from one another, as shown in Fig. 4. If the internal supply voltage is supplied to the memory device according to the external supply voltage, whereby Vext goes to the saturational level Vext at t1, the internal supply voltage remains lower than the minimum operating voltage Vdet over the time range A. As a consequence, an error may occur in the memory device.

Generally, the rise time of Vint for providing minimum operating voltage Vdet has taken approximately 6 µs. But recently, especially in hand-held systems, the IVC driver 200 is required to provide the internal supply voltage Vint to the memory device within µs. As shown Fig 3, because there is no power-up signal input to the active IVC controller 550, the internal voltage in accordance with the prior art is provided only by the standby IVC driver during the power-up period.

Laid-open publication US 2002/0089370 A discloses a circuit for generating an internal operating voltage according to the preamble of claim 1, in which the ramping voltage generator means is structured to generate a ramping voltage higher than the external power voltage ramped from zero to a saturation value during a power-up operation, so as to reduce or avoid any delay in providing the internal voltage. Typically this design leads to an overshoot of the internal voltage in a final stage of the power-up interval from which the internal voltage has to be decreased to its desired value.

It is the technical problem underlying the present invention to provide for a circuit and a method able to improve the generation of an internal operating voltage for use in a memory device as compared to the above-mentioned conventional approach, and in particular to provide an internal supply voltage for the memory device quicker than in this conventional approach.

The invention solves this problem by providing a circuit having the features of claim 1 and a method having the features of claim 14.

Advantageous embodiments of the invention are given in the subclaims, the wording of which is incorporated herewith into the description by reference to avoid unnecessary text repetitions.

Advantageous embodiments of the invention, as described in more detail below, as well as the conventional system explained above are shown in the accompanying drawings in which:
Fig. 1 is a block diagram of a conventional memory device,
Fig. 2 illustrates a conventional standby IVC driver,
Fig. 3 illustrates a conventional active IVC controller for producing an active IVC enable signal,
Fig. 4 is a timing diagram corresponding to Fig. 2,
Fig. 5 is a block diagram of a memory device according to the present invention,
Fig. 6 illustrates a first embodiment of the present invention,
Fig. 7 illustrates a power level detector,
Fig. 8 is a timing diagram of Fig. 7,
Fig. 9 illustrates an active IVC driver controller,
Fig. 10 illustrates an active IVC driver,
Fig. 11 illustrates another active IVC drivers,
Fig. 12 illustrates a voltage regulator,
Fig. 13 is a timing diagram corresponding to Fig. 6,
Fig. 14 illustrates a second embodiment of present invention, -
Fig. 15 is the third embodiment of present invention,
Fig. 16 illustrates a Vint and Vext short circuit, and
Fig. 17 is a timing diagram corresponding to Figs. 14 and 15.

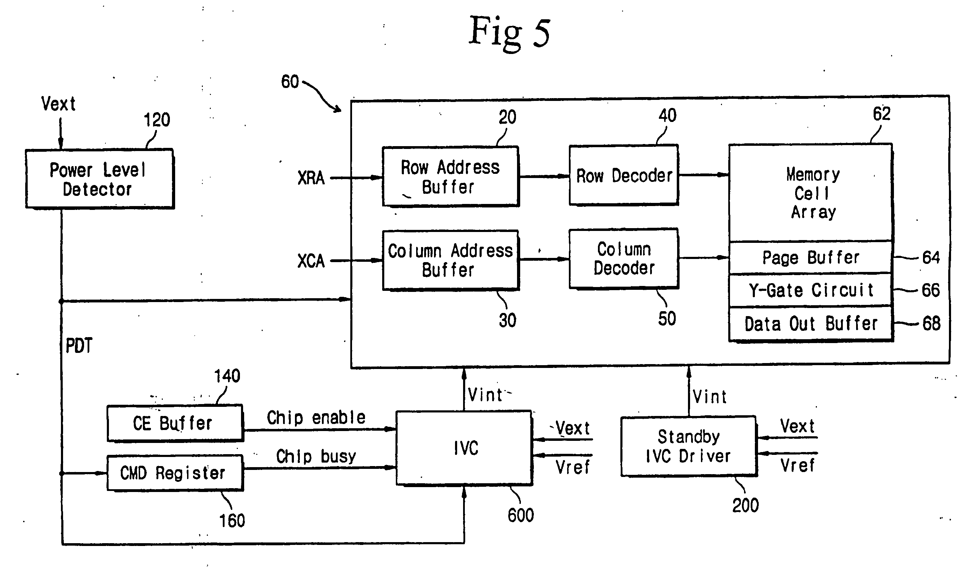

Referring to Fig. 5, the memory device comprises a power level detector 120, an Internal Voltage Converter (IVC) 600 and internal circuits 60. The internal circuits 60 will be understood to be the same as those of Fig. 1. Upon power up, a power level detector 120 generates a power-up signal PDT. The signal PDT activates the IVC 600 to produce internal supply voltage Vint. The IVC 600 provides the required internal supply voltage Vint to internal circuits 60.

Power-up is used broadly herein to refer to any intended ramping up of power from a nominal zero volts to a nominal supply voltage, whether such occurs at initial power-up or start-up, for example, of a hand-held, flash memory-based device such as a digital camera or after initial start-up but after a dormant (or so-called sleep) period wherein the power supplied to the device's internal circuits has been either diminished (e.g. to a standby level) or removed.

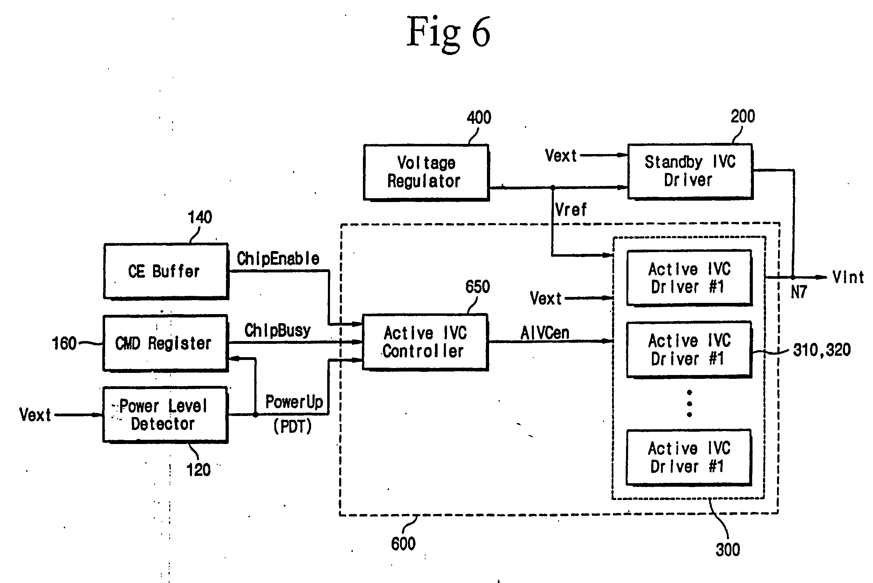

Fig. 6 is a block diagram illustrating a first embodiment of this invention. Fig. 6 comprises a power level detector 120, a CE Buffer 140, a CMD register 160, a Voltage Regulator 400 and an IVC 600 including an active IVC controller 650 and active drivers 300. In accordance with the prior art, the active IVC controller 650 is activated only when the CE Buffer 140 or the CMD register 160 is enabled. The CE Buffer 140 provides chip enable information and the CMD Register 160 provides read, program, and erase information. The power-up signal PDT of the power level detector 120 does not input to the IVC controller 650 but inputs instead to the CMD register 160 and internal circuits 60 only for resetting the memory device. In contrast to the prior art teachings by which no power up signal PDT inputs to the IVC controller 650, in accordance with the present invention, the signal PDT inputs to the IVC controller 650 during the power up period.

In other words, novel IVC controller 650 is activated whenever one of the three signals, the chip enable signal from CE buffer 140, the chip busy signal from CMD register 160 or the power up signal from power level detector 120, is active.

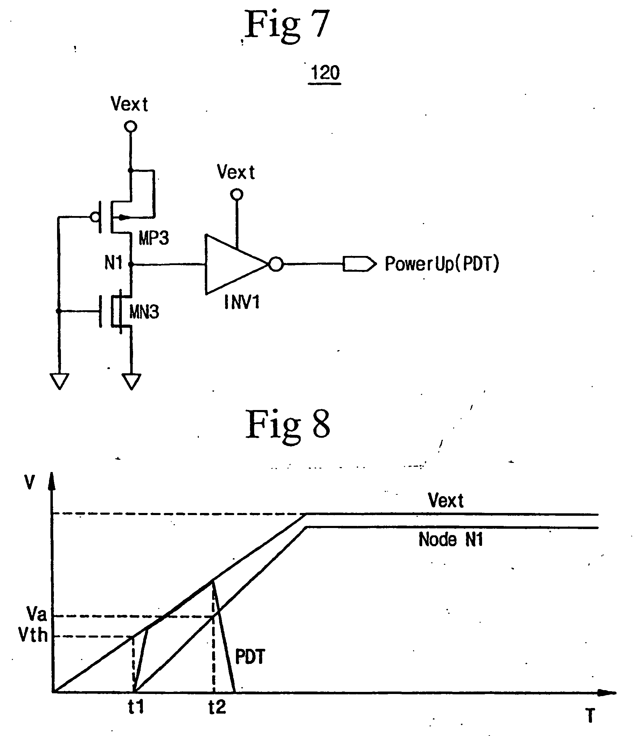

The power level detector 120 of the present invention is shown in Fig.7. There are many types of power level detectors. Although other power level detectors are contemplated as being within the spirit and scope of the invention, the featured power level detector 120 has a PMOS and an NMOS depletion transistor that are serially connected to each other, in accordance with the present invention. The gates of the two transistors are connected in common to ground. The source of the PMOS transistor MP3 is connected to the external voltage Vext, and the drain thereof is connected to node N1 and to the drain of the NMOS transistor MN3. An n-type well which is used for the bulk of the PMOS transistor MP3 is connected to the external supply voltage Vext having high potential. The source of the NMOS transistor MN3 is connected to ground. The NMOS transistor MN3 connected between the node N1 and ground is a depletion type and has a long channel, thus providing high resistance.

As shown in Fig 7 and 8, the level of node N 1 is ground level because of an NMOS depletion transistor MN3. When the external supply voltage Vext reaches to the threshold voltage Vth of PMOS transistor MP3, the PMOS transistor MP3 turns on at t1. After time t1, the node N ramps up from ground to the external supply voltage but does not reach the voltage Vext because of the NMOS depletion transistor MN3. At the same time, the power up signal PDT ramps up from ground to the voltage Vext and reaches the voltage Vext in a short time because NMOS transistor (not shown) of inverter INV1 is turned off. When the gate-to-source voltage Vgs of NMOS and PMOS transistor (not shown) in the inverter INV1 are the same, the power up signal PDT goes down toward ground level. In other words, when the node N1 level reaches a certain trip-point level Va at t2, the PDT goes logical LOW level. In general, the PDT is logical HIGH level before t2 and logical LOW level after t2. As a result, the power up period is finished after time t2.

During the power-up period, the power-up signal PDT goes HIGH and inputs to the IVC controller. The IVC (600 in Fig. 6)--which comprises the active IVC Controller 650, the active IVC drivers 300 and a standby IVC driver 200--receives the power-up signal PDT from power level detector 120.

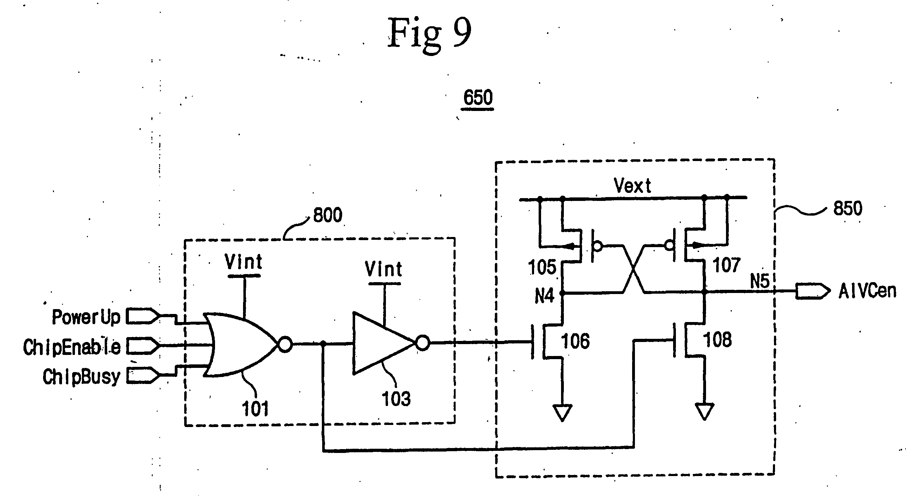

As shown in Figs. 5 and 9, the active IVC Controller 650 (see Fig. 9) receives the power-up signal PDT which is a logic HIGH. The active IVC controller 650 generates an active IVC enable signal AIVCen. The active IVC Controller 650 comprises control logic 800 (coupled to the internal supply voltage Vint) and a level shifter 850. The control logic 800 includes a NOR gate 101 and an inverter 103. The NOR gate 101 receives a power-up signal PDT, a chip enable signal ChipEnable and chip busy signal ChipBusy. According to this invention, because the power level detector (120 in Fig. 5) generates a power-up signal PDT at a logic HIGH, the output of the NOR gate 101 goes to a logic LOW. The level of the gate of the NMOS transistor 106 is a logic HIGH, which turns on the transistor 106 when the output of the inverter 103 goes HIGH. So the node N4 goes LOW and turns on the PMOS transistor 107. As a result, the external supply voltage Vext is provide to the node N5. Specifically, the output of the control logic 800 is shifted to the other level Vext, the same as the level of the active IVC enable signal AIVCen through the level shifter 850.

There are many types of level shifters 850. In this invention, the level shifter uses an external voltage Vext as a voltage source. Namely, the active IVC enable signal AIVCen is raised to the level of Vext. Those of skill in the art will appreciate that, within the spirit and scope of the invention, other types may be used.

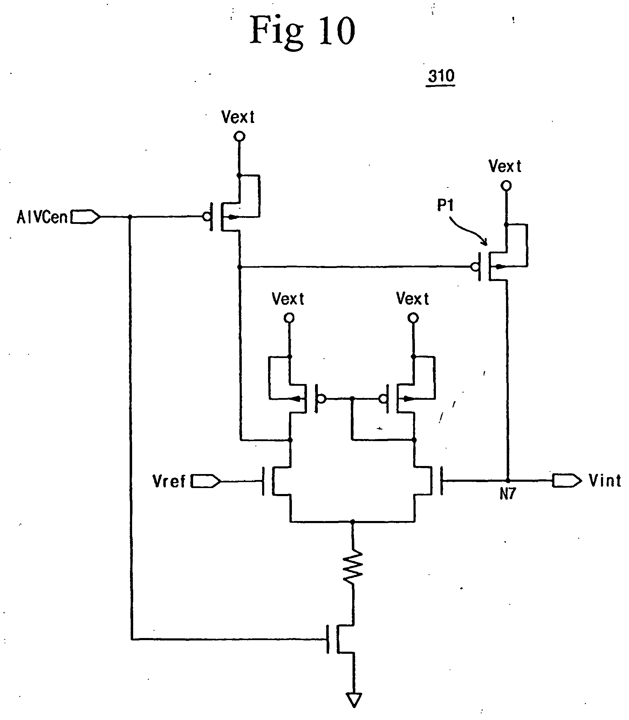

When the active IVC enable signal AIVCen (which is the output of the active IVC controller 650) inputs to the active IVC Drivers (300 in Fig. 6), the drivers (300) generate an internal voltage Vint at node N7. A representative one of the active IVC drivers is shown in Fig. 10. There are many types of active IVC drivers. In this invention, two such driver types will be described. Those of skill in the art will appreciate that, within the spirit and scope of the invention, other types may be used.

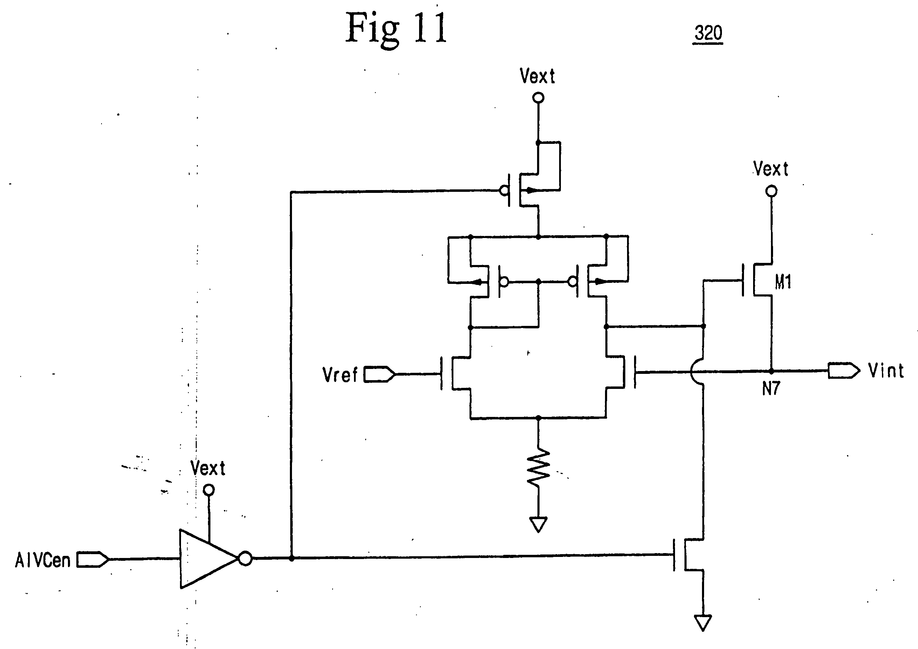

One of the active IVC drivers is shown in Fig. 10 and the other is shown in Fig. 11. The active IVC driver 310 of Fig 10 operates as follows. The external supply voltage Vext is supplied to the node N7 as an internal supply voltage Vint through the PMOS transistor P1. Similarly, the external supply voltage Vext is supplied to node N7 in active IVC driver 320 of Fig. 11 as an internal supply voltage Vint through the NMOS transistor M1. Each of the two active IVC drivers (310 of Fig. 10, 320 of Fig. 11) receives and is controlled by the active IVC enable signal AIVCen. In both cases, the driver 310, 320 receives a reference voltage signal Vref as well as the active IVC enable signal AIVCen.

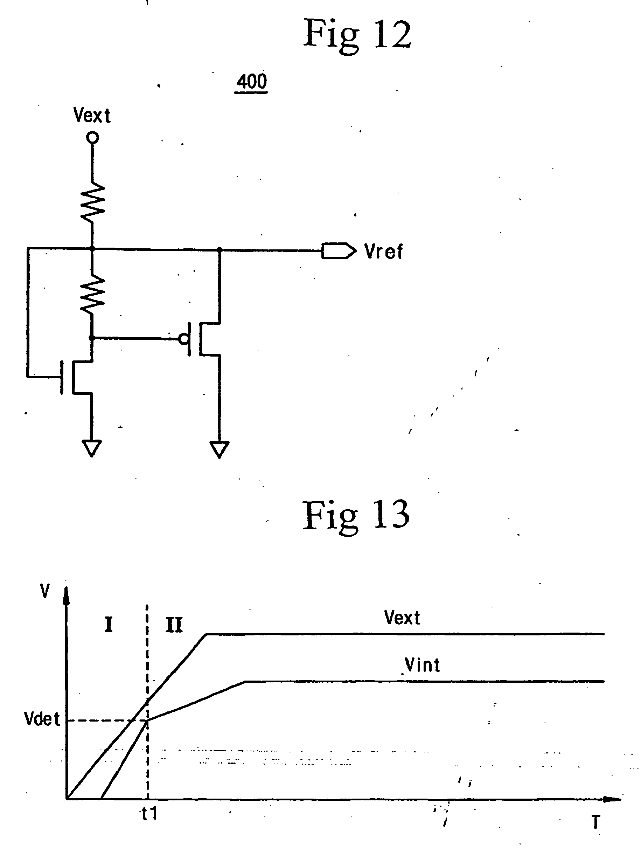

The reference voltage signal is generated by a Voltage Regulator 400, as illustrated in Fig. 12. Because any one of many known Voltage Regulators 400 can be used in this invention, it will not be further explained.

Referring next to Fig. 13, it will be appreciated that the active IVC driver (310 of Fig. 10, 320 of Fig. 11) has a high charge driving capability compared with the standby IVC driver (200 in Fig. 6). Accordingly, when the internal supply voltage Vint passes the external supply voltage Vext by way of the active IVC driver, the slope of the internal supply voltage Vint is greater than that of the standby IVC driver 200. Moreover, The slope of the internal supply voltage Vint is nearly as great as that of the external supply voltage Vext.

It is possible to use several active IVC drivers (300 in Fig. 6) to provide the internal supply voltage to the node N7. Preferably, plural active IVC drivers 300 are used to provide the internal supply voltage Vint. This increases the internal supply voltage ramping-up speed (slope) and minimizes the speed difference between the external supply voltage Vext and the internal supply voltage Vint. Thus, the internal supply voltage Vint can be provided to the internal circuits within the required shorter time in the newer and more demanding hand-held systems.

Indeed, the invention makes it possible to achieve power-up voltage ramp slopes up to at least two orders of magnitude higher than has been conventionally possible, rendering memory device turn-on times far less than the required 1µs maximum. This permits use of the invention in the most demanding digital camera applications, which may require as low as 1 microsecond power-up timing, rather than the several microsecond to millisecond ramp-up timing that conventional standby power techniques provided.

In Figs. 6, 7 and 13, during the power-up operation, the power level detector (120 in Figs. 6 and 7) generates the power-up signal PDT of a logic HIGH.

According to the level of the power level detector, the IVC generates the internal supply voltage. The internal supply voltage Vint ramps up quickly, closely following the ramp of the external supply voltage Vext, until the internal supply voltage reaches the minimum operating voltage Vdet, as shown in Fig 13.

As a result, the internal supply voltage rapidly goes to the Vdet level. After the power level detector (120 of Fig. 7) generates a logic LOW and the level of the node N1 of Fig 7 exceeds the Va level, the IVC driver (310 of Fig. 10, 320 of Fig. 11) stops providing the internal supply voltage Vint to the node N7. Thereafter, the internal supply voltage connected to the node N7 is supplied only the external supply voltage Vext from the standby IVC driver. As shown in Fig. 13, after passing the time t1 when the level of Vdet is reached, the slope of supplied voltage is equal to the slope of the internal supply voltage Vint from the standby IVC driver (200 of Fig. 6). Even though the slope of the internal supply voltage Vint after time t1 follows that of the standby IVC driver, because the internal supply voltage Vint already has achieved the minimum operating voltage Vdet within the required time, the system operates properly and without errors.

In contrast, the active IVC driver of the prior art operates only when the memory device receives the chip enable signal or chip busy signal (see Fig. 1). Moreover, the standby IVC Driver (200 of Fig. 1) provides only an internal voltage to the internal circuits during the power-up period. So, it is impossible to provide the internal supply voltage to the internal circuits within 1µs, which is the required time in recent systems.

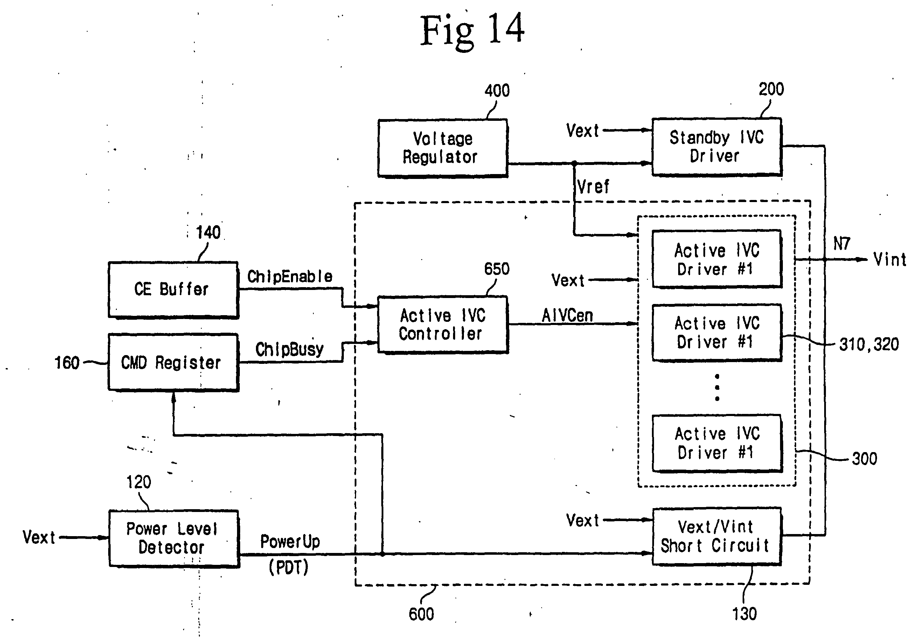

Fig. 14 illustrates a second embodiment of the present invention.

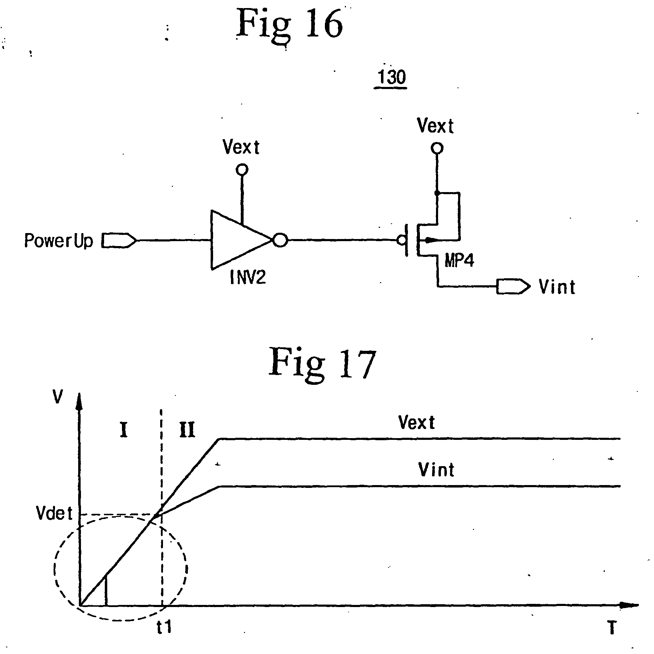

In this embodiment, the IVC 600 further comprises a Vint/Vext short circuit 130. The power-up signal PDT of the power level detector 120 does not input to the active IVC controller 650 but it does input to the Vint/Vext short circuit 130. The active IVC controller is activated by the CE Buffer 140 and CMD Register 160, as in the prior art. But, in important contrast, the internal supply voltage Vint is supplied to the node N7 by way of the Vint/Vext short circuit controlled by the power-up signal PDT. The Vint/Vext short circuit is shown in Fig. 16. As may be seen from Fig. 16, the power-up signal PowerUp (PDT) inputs to an inverter INV2 to turn on PMOS transistor MP4, effectively shorting Vext to Vint. (During the power-up period, the power-up signal PowerUp (PDT) goes to a logic HIGH. The gate of the PMOS transistor goes to logic LOW via an inverter INV2. The PMOS transistor MP4 turns on and the external supply voltage Vext is connected to the internal supply voltage Vint via the on transistor, effectively shorting Vext to Vint.).Within the spirit and scope of the invention, the PMOS transistor MP4 may change to an NMOS transistor (depletion or enhancement type.)

The beneficial result of electrically shorting the two voltages Vext and Vint is illustrated in Fig 17. During the power up, the internal supply voltage Vint ramps up and precisely tracks the external supply voltage Vext until time t1. At that time, the internal supply voltage reaches the minimum operating voltage Vdet. After the power-up signal PDT goes to a logic LOW, as described above in connection with the first embodiment of invention, the slope of the internal supply voltage Vint tracks that of the standby IVC driver (200 of Fig. 14).

As a result, it is possible to provide a quickly ramped-up internal supply voltage Vint within the system required time.

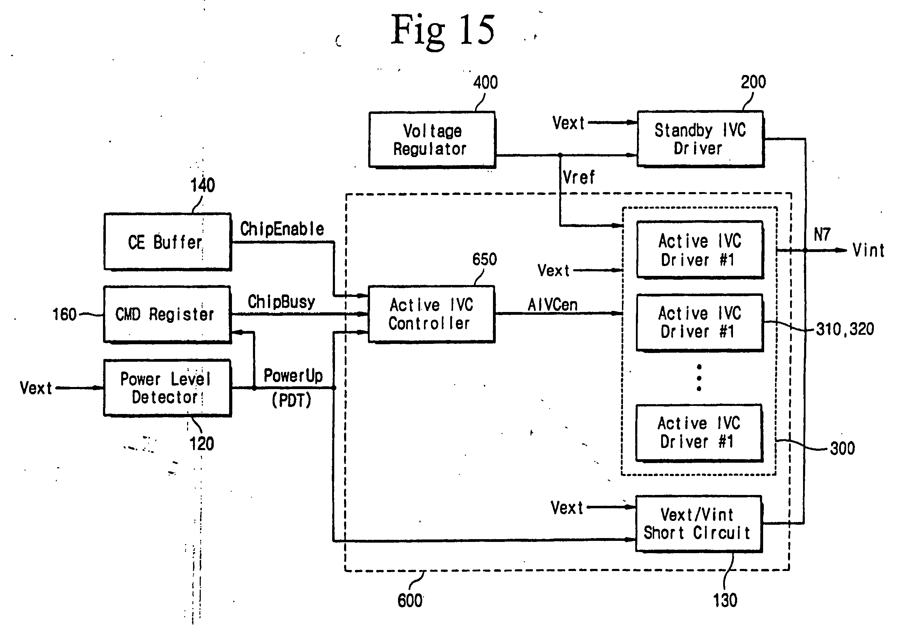

Fig. 15 is a third embodiment of the present invention. In this figure, the power-up signal PDT of the power-up detector 120 inputs to the active IVC controller and Vext/Vint short circuit 130. According as the power-up signal PDT concurrently inputs to the active IVC controller and Vext/Vint short circuit 130, the internal supply voltage Vint generated from the external supply voltage Vext ramps up more rapidly. In this hybrid embodiment, active IVC controller 650 has three inputs, PowerUp , ChipEnable and ChipBusy, as shown in Fig. 9 and as described above.

A person skilled in the art will be able to practice the present invention in view of the description present in this document, which is to be taken as a whole. Numerous details have been set forth in order to provide a more thorough understanding of the invention. In other instances, well-known features have not been described in detail in order not to obscure unnecessarily the invention.

While the invention has been disclosed in its preferred embodiments, the specific embodiments as disclosed and illustrated herein are not to be considered in a limiting sense. Indeed, it should be readily apparent to those skilled in the art in view of the present description that the invention may be modified in numerous ways. The inventor regards the subject matter of the invention to include all combinations and sub-combinations of the various elements, features, functions and/or properties disclosed herein.

The following claims define certain combinations and sub-combinations, which are regarded as novel and non-obvious. Additional claims for other combinations and sub-combinations of features, functions, elements and/or properties may be presented in this or a related document.

## Claims

1. A circuit for generating an internal operating voltage (Vint) for use in a memory device, the circuit comprising:
a power level detector (120) receiving an external voltage (Vext) for generating a power-up signal (PDT); and
a ramping voltage generator means (200, 600) coupled to the power level detector and structured to ramp the internal operating voltage in a power-up operation during which the external voltage increases up to a saturation level;
**characterized in that**
the ramping voltage generator means (200, 600) is structured to ramp the internal operating voltage (Vint), when receiving the power-up signal (PDT), up to a minimum operating voltage (Vdet) with a first ramping slope and from the minimum operating voltage to a final internal operating voltage with a second ramping slope, the first ramping slope being higher than the second ramping slope.

2. The circuit of claim 1, wherein the ramping voltage generator means comprises a standby voltage generator (200) and a ramping voltage generator (600), wherein during the power-up operation the standby voltage generator is operated until the final internal operating voltage is reached, while the ramping voltage generator (600) is operated until the minimum operating voltage is reached.

3. The circuit of claim 1 or 2, wherein the power-up signal is a wake-up signal representing an end to a period of dormant memory device operation.

4. The circuit of claim 2 or 3, wherein the ramping voltage generator is provided by an internal voltage converter (600), comprising:
a voltage controller (650) having an input for receiving a power-up signal, and for generating a control signal when the power-up signal is received; and
one or more voltage or controller drivers (300) having separate inputs and a common output, each voltage or controller driver structured to raise the internal operating voltage on the common output when the control signal is received at its respective input.

5. The circuit of claim 4, wherein the voltage controller comprises:
a set of control logic having a plurality of inputs; and
a voltage level shifter coupled to an output of the control logic.

6. The circuit of claim 5, wherein one of the plurality of inputs receives the power-up signal.

7. The circuit of claim 5 or 6, wherein the voltage level shifter is structured to accept an output from the control logic and generate the control signal.

8. The circuit of any of claims 5 to 7, wherein at least one of the voltage drivers comprises:
a first circuit portion coupled to an external voltage line; and
a voltage raising circuit portion coupled to the first circuit portion and coupled to the common output, the voltage raising circuit structured to raise the voltage of the common output when the control signal is received.

9. The circuit of any of claims 2 to 8, wherein the ramping voltage generator or at least one or all of the one or more voltage drivers turns off after the minimum operating voltage is reached.

10. The circuit of any of claims 4 to 9, wherein the one or more voltage drivers have more voltage raising capacity than the standby voltage generator.

11. The circuit of any of claims 2 to 10, wherein the ramping voltage generator comprises a shorting circuit (130) coupled to an external voltage line and structured to short the external voltage line to an internal voltage line when the shorting circuit receives the power-up signal.

12. The circuit of claim 11, wherein the shorting circuit (130) couples the common output of the voltage or controller drivers to the external voltage when the shorting circuit receives the power-up signal.

13. The circuit of claim 11 or 12, wherein the shorting circuit comprises:
a PMOS transistor having a source coupled to the external voltage line or external voltage, a control gate for receiving the power up signal or an output of the power-up signal, and having a drain coupled to the internal voltage line or common output,
and/or a depletion-type NMOS transistor having a source coupled to the external voltage line or external voltage, a control gate for receiving the power-up signal or control signal and a drain coupled to the internal voltage line or common output.

14. A method for generating an internal operating voltage for use in a memory device, comprising:
detecting a power-up signal (PDT) generated in response to a supplied external voltage (Vext);
generating an enable signal (AVIVCen) when the power-up signal is detected; and
providing the enable signal to one or more voltage ramping circuits (310, 320);
**characterized by**
ramping the internal operating voltage, when the enable signal is provided to the one or more voltage ramping circuits (310, 320), from zero volts to a minimum operating voltage (Vdet) with a first ramping slope and then ramping it to a final internal operating voltage with a second ramping slope of a standby voltage generator (200), the first ramping slope being higher than the second ramping slope.

15. The method of claim 14 which further comprises disabling the one or more voltage ramping circuits when the internal operating voltage has reached the minimum operating level.

16. The method of claim 14 or 15 which further comprises providing also a standby voltage generator operative concurrent with the operation of the one or more voltage ramping circuits, thereby to increase the rise time of the voltage ramp, at least until the internal operating voltage has reached the minimum operating level.

## Patentansprüche

1. Schaltung zum Erzeugen einer internen Betriebsspannung (Vint) zur Verwendung in einem Speicherbauelement, wobei die Schaltung umfasst:
- einen Leistungspegeldetektor (120), der eine externe Spannung (Vext) zum Erzeugen eines Einschaltsignals (PDT) empfängt, und
- ein Rampenspannungsgeneratormittel (200, 600), das mit dem Leistungspegeldetektor gekoppelt ist und strukturiert ist, um die interne Betriebsspannung in einem Einschaltvorgang, während dem die externe Spannung auf einen Sättigungspegel ansteigt, rampenförmig hochzufahren,
**dadurch gekennzeichnet, dass**
- das Rampenspannungsgeneratormittel (200, 600) strukturiert ist, um die interne Betriebsspannung (Vint), wenn das Einschaltsignal (PDT) empfangen wird, mit einer ersten Rampensteigung bis auf eine minimale Betriebsspannung (Vdet) und mit einer zweiten Rampensteigung von der minimalen Betriebsspannung bis auf eine finale interne Betriebsspannung hochzufahren, wobei die erste Rampensteigung größer als die zweite Rampensteigung ist.

2. Schaltung nach Anspruch 1, wobei das Rampenspannungsgeneratormittel einen Bereitschaftsspannungsgenerator (200) und einen Rampenspannungsgenerator (600) umfasst, wobei der Bereitschaftsspannungsgenerator während des Einschaltvorgangs bis zum Erreichen der finalen internen Betriebsspannung betrieben wird, während der Rampenspannungsgenerator (600) bis zum Erreichen der minimalen Betriebsspannung betrieben wird.

3. Schaltung nach Anspruch 1 oder 2, wobei das Einschaltsignal ein Aufwachsignal ist, das ein Ende einer Ruheperiode des Speicherbauelementbetriebs repräsentiert.

4. Schaltung nach Anspruch 2 oder 3, wobei der Rampenspannungsgenerator durch einen internen Spannungswandler (600) zur Verfügung gestellt wird, der folgende Komponenten umfasst:
- eine Spannungssteuereinheit (650), die einen Eingang zum Empfangen eines Einschaltsignals aufweist und ein Steuersignal erzeugt, wenn das Einschaltsignal empfangen wird, und
- einen oder mehrere Spannungs- oder Steuerungstreiber (300), die separate Eingänge und einen gemeinsamen Ausgang aufweisen, wobei jeder Spannungs- oder Steuerungstreiber strukturiert ist, um die interne Betriebsspannung an dem gemeinsamen Ausgang zu erhöhen, wenn das Steuersignal an seinem entsprechenden Eingang empfangen wird.

5. Schaltung nach Anspruch 4, wobei die Spannungssteuereinheit umfasst:
- einen Steuerlogiksatz, der eine Mehrzahl von Eingängen aufweist, und
- einen Spannungspegelschieber, der mit einem Ausgang der Steuerlogik gekoppelt ist.

6. Schaltung nach Anspruch 5, wobei einer der Mehrzahl von Eingängen das Einschaltsignal empfängt.

7. Schaltung nach Anspruch 5 oder 6, wobei der Spannungspegelschieber strukturiert ist, um eine Ausgabe der Steuerlogik zu empfangen und das Steuersignal zu erzeugen.

8. Schaltung nach einem der Ansprüche 5 bis 7, wobei wenigstens einer der Spannungstreiber umfasst:
- einen ersten Schaltungsteil, der mit einer externen Spannungsleitung gekoppelt ist, und
- einen Spannungserhöhungsschaltungsteil, der mit dem ersten Schaltungsteil gekoppelt ist und mit dem gemeinsamen Ausgang gekoppelt ist, wobei die Spannungserhöhungsschaltung strukturiert ist, um die Spannung an dem gemeinsamen Ausgang zu erhöhen, wenn das Steuersignal empfangen wird.

9. Schaltung nach einem der Ansprüche 2 bis 8, wobei der Rampenspannungsgenerator oder wenigstens einer oder alle der einen oder mehreren Spannungstreiber abgeschaltet sind, nachdem die minimale Betriebsspannung erreicht ist.

10. Schaltung nach einem der Ansprüche 4 bis 9, wobei der eine oder die mehreren Spannungstreiber eine größere Spannungserhöhungskapazität als der Bereitschaftsspannungsgenerator aufweisen.

11. Schaltung nach einem der Ansprüche 2 bis 10, wobei der Rampenspannungsgenerator eine Kurzschlussschaltung (130) umfasst, die mit einer externen Spannungsleitung gekoppelt und strukturiert ist, um die externe Spannungsleitung mit einer internen Spannungsleitung kurzzuschließen, wenn die Kurzschlussschaltung das Einschaltsignal empfängt.

12. Schaltung nach Anspruch 11, wobei die Kurzschlussschaltung (130) den gemeinsamen Ausgang der Spannungs- oder Steuerungstreiber mit der externen Spannung koppelt, wenn die Kurzschlussschaltung das Einschaltsignal empfängt.

13. Schaltung nach Anspruch 11 oder 12, wobei die Kurzschlussschaltung umfasst:
- einen PMOS-Transistor, der eine Source, die mit der externen Spannungsleitung oder der externen Spannung gekoppelt ist, ein Steuergate zum Empfangen des Einschaltsignals oder einer Ausgabe des Einschaltsignals und eine Drain aufweist, die mit der internen Spannungsleitung oder dem gemeinsamen Ausgang gekoppelt ist, und/oder
- einen NMOS-Transistor vom Verarmungstyp, der eine Source, die mit der externen Spannungsleitung oder der externen Spannung gekoppelt ist, ein Steuergate zum Empfangen des Einschaltsignals oder des Steuersignals und eine Drain aufweist, die mit der internen Spannungsleitung oder dem gemeinsamen Ausgang gekoppelt ist.

14. Verfahren zum Erzeugen einer internen Betriebsspannung zur Verwendung in einem Speicherbauelement, umfassend.
- Detektieren eines Einschaltsignals (PDT), das in Reaktion auf eine angelegte externe Spannung (Vext) erzeugt wird,
- Erzeugen eines Freigabesignals (AIVCen), wenn das Einschaltsignal detektiert wird, und
- Bereitstellen des Freigabesignals an eine oder mehrere Spannungsrampenschaltungen (310, 320),
**dadurch gekennzeichnet, dass**
- Die interne Betriebsspannung (Vint), wenn das Freigabesignal an die eine oder mehreren Spannungsrampenschaltungen (310, 320) angelegt wird, mit einer ersten Rampensteigung von null Volt bis auf eine minimale Betriebsspannung (Vdet) und dann mit einer zweiten Rampensteigung eines Bereitschaftsspannungsgenerators (200) bis auf eine finale interne Betriebsspannung rampenförmig hochgefahren wird, wobei die erste Rampensteigung größer als die zweite Rampensteigung ist.

15. Verfahren nach Anspruch 14, wobei die eine oder mehreren Spannungsrampenschaltungen abgeschaltet werden, wenn die interne Betriebsspannung den minimalen Betriebsspannungspegel erreicht hat.

16. Verfahren nach Anspruch 14 oder 15, wobei zudem ein Bereitschaftsspannungsgenerator bereitgestellt wird, der gleichzeitig zum Betrieb der einen oder mehreren Spannungsrampenschaltungen wenigstens solange betrieben wird, bis die interne Betriebsspannung den minimalen Betriebspegel erreicht hat, wodurch die Anstiegsgeschwindigkeit der Spannungsrampe erhöht wird.

## Revendications

1. Circuit pour générer une tension de fonctionnement interne (Vint) destinée à être utilisée dans un dispositif de mémoire, le dispositif comprenant :
un détecteur de niveau de puissance (120) recevant une tension externe (Vext) pour générer un signal de mise sous tension (PDT) ; et
des moyens formant générateur de rampe de tension (200, 600) couplés au détecteur de niveau de puissance et structurés pour faire effectuer une rampe à la tension de fonctionnement interne lors d'une opération de mise sous tension pendant laquelle la tension externe augmente jusqu'à un niveau de saturation ;
**caractérisé en ce que** :
les moyens formant générateur de rampe de tension (200, 600) sont structurés pour faire effectuer une rampe à la tension de fonctionnement interne (Vint) lors de la réception du signal de mise sous tension (PDT) jusqu'à une tension de fonctionnement minimale (Vdet) avec une première pente de rampe, et de la tension de fonctionnement minimale à une tension de fonctionnement interne finale avec une deuxième pente de rampe, la première pente de rampe étant supérieure à la deuxième pente de rampe.

2. Circuit selon la revendication 1, dans lequel les moyens formant générateur de rampe de tension comprennent un générateur de tension d'attente (200) et un générateur de rampe de tension (600), où, durant l'opération de mise sous tension, on fait fonctionner le générateur de tension d'attente jusqu'à ce que la tension de fonctionnement interne finale soit atteinte, tandis que l'on fait fonctionner le générateur de rampe de tension (600) jusqu'à ce que la tension de fonctionnement minimale soit atteinte.

3. Circuit selon la revendication 1 ou 2, dans lequel le signal de mise sous tension est un signal d'éveil représentant une fin d'une période de fonctionnement dormant d'un dispositif de mémoire.

4. Circuit selon la revendication 2 ou 3, dans lequel le générateur de rampe de tension est constitué par un convertisseur de tension interne (600), comprenant :
un dispositif de commande de tension (650) comportant une entrée pour recevoir un signal de mise sous tension, et pour générer un signal de commande lorsque le signal de mise sous tension est reçu ; et
un ou plusieurs dispositifs d'attaque de tension ou de dispositif de commande (300) comportant des entrées séparées et une sortie commune, chaque dispositif d'attaque de tension ou de dispositif de commande étant structuré de façon à élever la tension de fonctionnement interne sur la sortie commune lorsque le signal de commande est reçu sur son entrée respective.

5. Circuit selon la revendication 4, dans lequel le dispositif de commande de tension comprend :
un ensemble de logique de commande comportant une pluralité d'entrées ; et
un dispositif de décalage de niveau de tension couplé à une sortie de la logique de commande.

6. Circuit selon la revendication 5, dans lequel l'une de la pluralité d'entrées reçoit le signal de mise sous tension.

7. Circuit selon la revendication 5 ou 6, dans lequel le dispositif de décalage de niveau de tension est structuré de façon à accepter une sortie de la logique de commande et à générer le signal de commande.

8. Circuit selon l'une quelconque des revendications 5 à 7, dans lequel au moins l'un des dispositifs d'attaque de tension comprend :
une première partie de circuit couplée à une ligne de tension externe ; et
une partie de circuit d'élévation de tension couplée à la première partie de circuit et couplée à la sortie commune, le circuit d'élévation de tension étant structuré de façon à élever la tension de la sortie commune lorsque le signal de commande est reçu.

9. Circuit selon l'une quelconque des revendications 2 à 8, dans lequel le générateur de rampe de tension ou au moins l'un ou la totalité parmi les dispositifs d'attaque de tension au nombre d'un ou de plusieurs se mettent hors service après que la tension de fonctionnement minimale a été atteinte.

10. Circuit selon l'une quelconque des revendications 4 à 9, dans lequel les dispositifs d'attaque de tension au nombre d'un ou de plusieurs ont davantage de capacité d'élévation de tension que le générateur de tension d'attente.

11. Circuit selon l'une quelconque des revendications 2 à 10, dans lequel le générateur de rampe de tension comprend un circuit de court-circuit (130) couplé à une ligne de tension externe et structuré pour mettre en court-circuit la ligne de tension externe avec une ligne de tension interne lorsque le circuit de court-circuit reçoit le signal de mise sous tension.

12. Circuit selon la revendication 11, dans lequel le circuit de court-circuit (130) couple la sortie commune des dispositifs d'attaque de tension ou de dispositif de commande à la tension externe lorsque le circuit de court-circuit reçoit le signal de mise sous tension.

13. Circuit selon la revendication 11 ou 12, dans lequel le circuit de court-circuit comprend :
un transistor métal-oxyde-semiconducteur à canal p (PMOS) comportant une source couplée à la ligne de tension externe ou à une tension externe, une grille de commande pour recevoir le signal de mise sous tension ou une sortie du signal de mise sous tension, et comportant un drain couplé à la ligne de tension interne ou à une sortie commune,
et/ou un transistor métal-oxyde-semiconducteur à canal n (NMOS) du type à appauvrissement comportant une source couplée à la ligne de tension externe ou à une tension externe, une grille de commande pour recevoir le signal de mise sous tension ou un signal de commande et un drain couplé à la ligne de tension interne ou à une sortie commune.

14. Procédé pour générer une tension de fonctionnement interne destinée à être utilisée dans un dispositif de mémoire, comprenant :
la détection d'un signal de mise sous tension (PDT) généré en réponse à une tension externe délivrée (Vext) ;
la génération d'un signal de validation (AVIVCen) lorsque le signal de mise sous tension est détecté ; et
la délivrance du signal de validation à un ou plusieurs circuits de rampe de tension (310, 320) ;
**caractérisé par** :
le fait de faire effectuer une rampe à la tension de fonctionnement interne, lorsque le signal de validation est délivré aux circuits de rampe de tension au nombre d'un ou de plusieurs (310, 320), de zéro volt à une tension de fonctionnement minimale (Vdet) avec une première pente de rampe, puis le fait de lui faire effectuer une rampe jusqu'à une tension de fonctionnement interne finale avec une deuxième pente de rampe d'un générateur de tension d'attente (200), la première pente de rampe étant supérieure à la deuxième pente de rampe.

15. Procédé selon la revendication 14, qui comprend de plus l'invalidation des circuits de rampe de tension au nombre d'un ou de plusieurs lorsque la tension de fonctionnement interne a atteint le niveau de fonctionnement minimal.

16. Procédé selon la revendication 14 ou 15, qui comprend de plus également la disposition d'un générateur de tension d'attente fonctionnant concurremment au fonctionnement des circuits de rampe de tension au nombre d'un ou de plusieurs, de façon à augmenter ainsi le temps d'élévation de la rampe de tension, au moins jusqu'à ce que la tension de fonctionnement interne ait atteint le niveau de fonctionnement minimal.
